# EUROPEAN PATENT APPLICATION

(11) **EP 1 898 231 A1**
(43) Date of publication of application: **12.03.2008**
(21) Application number: 07016312.6
(22) Date of filing: 20.08.2007
(51) Int. Cl.: G01S 7/03, H05K 5/00, H05K 5/02

(54) **Radar device**

(30) Priority: 07.09.2006 JP 2006243303
(71) Applicant: Hitachi, Ltd., Chiyoda-ku Tokyo 100-8280 (JP)
(72) Inventor: Ouchi, Shiro, c/oHitachi, Ltd., I.P. Group, Tokyo 100-8220 (JP); Isono, Tadashi, Hitachinaka-shi, Ibaraki-ken (JP); Matsuura, Kazuo, c/oHitachi, Ltd., I.P. Group, Tokyo 100-8220 (JP); Sasada, Yoshiyuki, c/oHitachi, Ltd., I.P. Group, Tokyo 100-8220 (JP)
(74) Representative: Beetz & Partner

(57) **Abstract**

In a radar device, in order to make it simple to attach a connector to a housing and connect a control circuit board to an antenna module, to make it possible to automate assembly, and to achieve downsizing and reduction of weight, the radar device is provided with a resin housing (1) having upper and lower opening portions, and a control circuit board (5) attached to the resin housing (1), a metal front cover (2) and a metal rear cover (3) are arranged so as to close the upper and lower opening portions of the resin housing (1), an opening portion (21) is formed in the metal front cover (2), and an antenna module (4) is arranged in the opening portion (21) so as to be firmly attached, whereby the radar device can be assembled from one side, it is possible to improve efficiency of assembling work and it is possible to achieve downsizing and cost reduction of the radar device.

## Description

### Field of the Invention

The present invention relates to a radar device which is mounted on a motor vehicle and is used for a safety control of the motor vehicle such as to detect an object in back and forth and right and left directions of the motor vehicle or the like.

### Description of Related Art

There has been known an in-vehicle electric wave type radar device which measures a distance or a relative speed to a vehicle, an obstacle and the like on back and forth and right and left sides, by using a mill wave band (60 to 77 GHz) electric wave having a small attenuation of an electric wave beam even in a bad weather in which a fog exists, and reaching a great distance.

As the in-vehicle electric wave type radar device mentioned above, there are structures shown in JP-A-10-261917 and JP-A-2001-324561.

The radar device shown in JP-A-10-261917 is structured such that an antenna, a high-frequency circuit portion and a control circuit portion are piled up in this order so as to be accommodated in an inner portion of a casing, and are fixed to the casing by screws or the like, a ground potential metal layer is provided between the high-frequency circuit portion and the control circuit portion, and a through hole is formed in the ground potential metal layer, and is connected by a core wire coated by a glass layer, thereby forming an electric connection between the control circuit portion existing on a back surface of the ground potential metal layer and the high-frequency circuit portion existing on a front surface.

The radar device shown in JP-A-2001-324561 is structured such that a control circuit mounting electronic parts thereon is installed in a casing made of a metal such as an aluminum die casting or the like, an antenna module mounting a transmitting antenna and a receiving antenna on an antenna base made of a metal is arranged in an opening portion of the casing, and the antenna module is covered by a radome, whereby the control circuit mounting the electronic parts thereon and the antenna module are surrounded by the housing constituted by the casing and the radome.

Further, the connector achieving the electric connection to an external device is structured such as to be mounted to the housing via an O-ring by a screw, and a GND which is common in the control circuit and the antenna module is electrically connected to the base and the housing, and is connected to a vehicle body GND only via a capacitive impedance.

In the conventional radar device mentioned above, the antenna module is arranged within the housing constituted by the casing and the radome, and any special consideration for a heat generated in the antenna module is not taken. Accordingly, if it is intended to downsize the radar device, a contact area with an ambient air becomes small, and the heat generated from the antenna module is not sufficiently discharged to an external portion, so that the antenna module comes to a high temperature, a characteristic of the electric wave is changed, and there is a case that a send and receive is stopped at the worst.

Further, in the conventional radar device, since the electric connection between the control circuit portion existing on the back surface of the ground potential metal layer and the high-frequency circuit portion existing on the front surface is formed by forming the through hole in the ground potential metal layer, and connecting by the core wire coated by the glass layer, and the connector is attached to the housing by the O-ring and the screw, it is complicated to attach the connector to the housing, connect between the control circuit boards and connect the control circuit board and the antenna module, and it is impossible to achieve a compact and light structure and a cost increase is caused as well as it is hard to automate an assembly.

On the other hand, in order to automatically assembling the radar device, it is desirable to assemble the constituting members in order from one side, however, since it is necessary to expose the antenna to the front surface in the radar, it is impossible to employ such a structure as a general in-vehicle electronic device as it is.

### Summary of The Invention

The present invention aims at improving the points mentioned above, and an object of the present invention is to provide a radar device in which a radar device is easily assembled by making a housing of the radar device of a resin, making a front cover and a rear cover of metal, and firmly attaching an antenna module to the metal front cover, and it is possible to achieve downsizing and cost reduction.

In order to achieve the object mentioned above, a radar device in accordance with the present invention is basically provided with a resin housing having opening portions on upper and lower sides, a control circuit board mounted within the housing, a metal front cover attached to the housing so as to close the upper opening portion of the housing, and/or a metal rear cover attached to the housing so as to close the lower opening portion of the housing, and/or the antenna module is attached to the front cover.

Further, a radar device in accordance with the present invention is provided with a resin housing having opening portions on upper and lower sides, a control circuit board provided with a control circuit and mounted within the housing, a metal front cover attached to the housing so as to close the upper opening portion of the housing, and/or a metal rear cover attached to the housing so as to close the lower opening portion of the housing, an opening portion is provided in the front cover, a peripheral edge of the antenna module is firmly attached to an opening edge of the opening portion, and/or the opening portion is coated by a radome having a good electric wave permeability.

In the present invention, since the peripheral edge of the antenna module is firmly attached to the opening edge of the opening portion of the metal front cover, heat generated by the antenna module is conducted to the metal front cover from the peripheral edge thereof, and the heat conducted to the front cover is discharged to an ambient air from the portion of the front cover which is in contact with the ambient air. Accordingly, even if the radar device is downsized, the antenna module is efficiently cooled and does not come to a high temperature. Therefore, it is possible to stably transmit and receive the electric wave. Further, since the rear cover covering the outer side of the control circuit board is made of metal, the heat generated from the control circuit board is discharged from the rear cover. Further, in accordance with the present invention, since the housing, the control circuit board and the rear cover can be assembled in order from one side to the front cover in
which the antenna module and the radome are fixed to the opening portion, it is possible to easily assemble the radar device, and the present invention is suitable for automatically assembling the radar device.

Further, in accordance with the present invention, a connector portion is integrally formed with the resin housing in the radar device, and a relay terminal relaying the antenna module and the control circuit board, and a connector terminal are provided in accordance with an insert mold forming.

Further, a radar device in accordance with the present invention comprises a housing having opening portions on upper and lower sides and made of resin and metal, a circuit control board provided with a control circuit and mounted within the housing, a metal front cover attached to the housing so as to close the upper opening portion of the housing, and/or a metal rear cover attached to the housing so as to close the lower opening portion of the housing, the housing is structured by resin in a portion in which a relay terminal relaying the antenna module and the control circuit board is arranged, and a portion in which the connector portion is provided, the connector portion is integrally formed with the housing, the relay terminal and the connector terminal are provided in accordance with an insert mold forming, an opening portion is provided in the front cover, a peripheral edge of the antenna module is firmly attached to an opening edge of the opening portion, and the opening portion is coated by a radome having a good electric wave permeability.

In the present invention, since the peripheral edge of the antenna module is firmly attached to the opening edge of the opening portion of the metal front cover, heat generated by the antenna module is conducted to the metal front cover from the peripheral edge thereof, and the heat conducted to the front cover is discharged to an ambient air from the portion of the front cover which is in contact with the ambient air. Accordingly, even if the radar device is downsized, the antenna module is efficiently cooled and does not come to a high temperature. Therefore, it is possible to stably transmit and receive the electric wave. Further, since the rear cover covering the outside of the control circuit board is made of metal, and many of the portions of the housing are made of metal, the heat generated from the elements of the control circuit board is discharged from the rear cover and the housing. In accordance with the present invention, since the radar device can be simply assembled by assembling the housing, the control circuit board and the rear cover in order from one side to the front cover in which the antenna module and the radome are fixed to the opening portion, the present invention is suitable for automatically assembling the radar device. Further, since the present invention is structured by resin in the portion in which the relay terminal relaying the antenna module and the control circuit board is arranged, and the portion in which the connector portion is provided, the connector portion can be simply provided by being integrally formed with the housing, and the relay terminal and the connector terminal can be provided in the housing in an insulating state without any trouble in accordance with an insert mold forming.

In accordance with the present invention, the front cover and the rear cover in the radar device are attached to the housing by engaging the screws from the rear cover with the front cover.

In the radar device in accordance with the present invention, the connection portion of the antenna module and the connection portion of the relay terminal are arranged close to each other, and are connected in accordance with wire bonding, soldering of a lead wire or the like.

In the radar device in accordance with the present invention, the connection portion of the control circuit board and the connection portion of the connector terminal are arranged close to each other, the connection portion of the control circuit board and the connection portion of the relay terminal are arranged close to each other, and they are respectively connected in accordance with wire bonding, soldering of a lead wire or the like.

In accordance with the present invention, the metal rear cover in the radar device is provided with a convex block at least on an inner surface.

In accordance with the present invention, since it is possible to efficiently cool the antenna module, it is possible to downsize the radar device, and it is possible to assemble the housing, the control circuit board and the rear cover in order from one side to the front cover in which the antenna module and the radome are fixed to the opening portion. Accordingly, it is possible to efficiently automate and execute the assembling work of the radar device, and it is possible to achieve cost reduction.

The above features can be combined in any way partly or as a whole.

Other objects, features and advantages of the invention will become apparent from the following description of the embodiments of the invention taken in conjunction with the accompanying drawings.

### Brief Description of Several Views of Drawings

Fig. 1 is an assembled perspective view of a radar apparatus in accordance with an embodiment of the present invention;
Fig. 2 is an exploded perspective view of the radar apparatus in accordance with the embodiment of the present invention;
Fig. 3 is a cross sectional view of the radar apparatus in accordance with the embodiment of the present invention;
Fig. 4 is a plan view of a housing 1 of the radar apparatus in accordance with the embodiment of the present invention;
Fig. 5 is a perspective view of a front cover 2 of the radar apparatus in accordance with the embodiment of the present invention;
Fig. 6 is a perspective view showing details of a rear cover 3 of the radar apparatus in accordance with the embodiment of the present invention;
Fig. 7 is a plan view showing details of a control circuit board of the radar apparatus in accordance with the embodiment of the present invention, in which the control circuit board is attached to the housing; and
Fig. 8 is a plan view of a case that the housing 1 of the radar apparatus in accordance with the embodiment of the present invention is structured by resin and metal.

### Detailed Description of the Invention

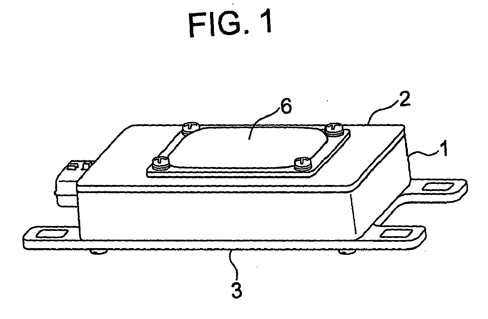

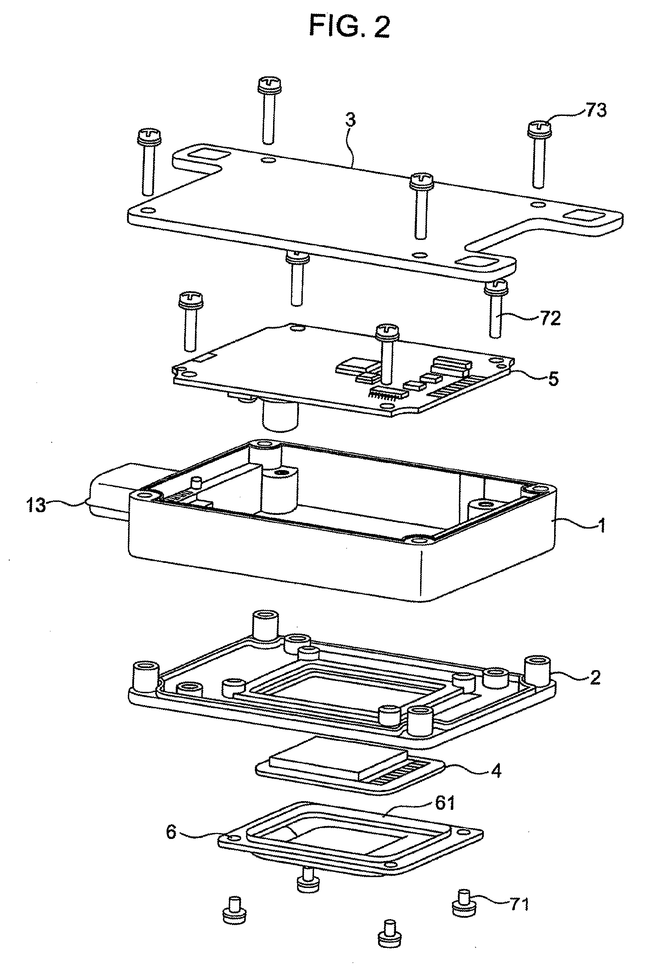

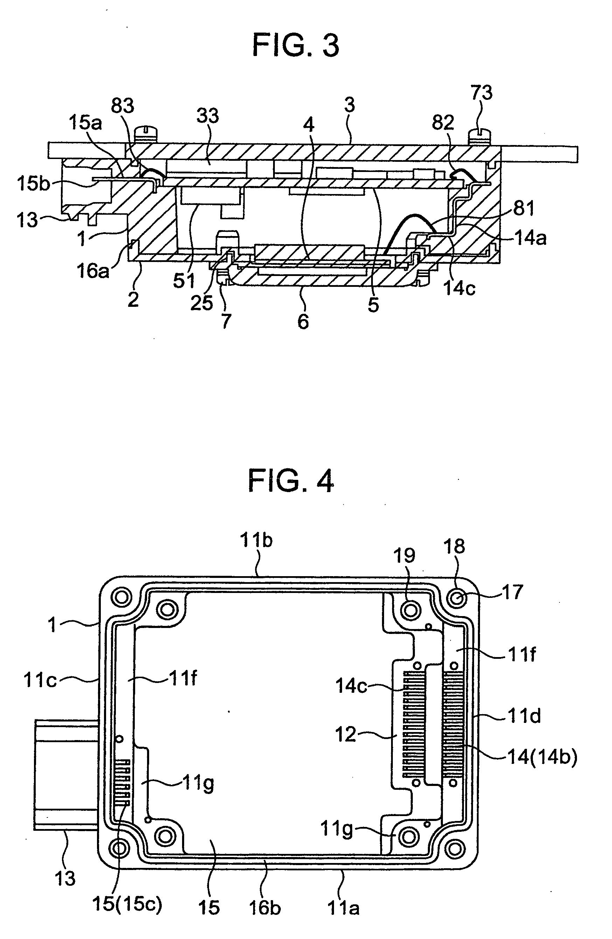

A description will be given of a radar apparatus corresponding to an embodiment in accordance with the present invention with reference to the accompanying drawings. Fig. 1 is an assembled perspective view of the radar apparatus in accordance with the present embodiment, Fig. 2 is an exploded perspective view of the radar apparatus in accordance with the present embodiment, and Fig. 3 is a cross sectional view of the radar apparatus in accordance with the present embodiment.

The radar device is constituted by a housing 1, a front cover 2, a rear cover 3, an antenna module 4 transmitting and receiving an electric wave, a control circuit board 5, and a radome 6. The antenna module 4 has a known structure, emits the electric wave and receives a reflected electric wave. The radome 6 is structured by a material having a good electric wave permeability, and a narrow convex groove 61 is formed in an outer periphery.

Fig. 4 is a plan view showing details of a first embodiment of the housing 1. The housing 1 is formed in a rectangular shape by synthetic resin, opening portions are formed on upper and lower sides of the housing 1, and the housing 1 is constructed by front, rear, left and right side walls 11a, 11b, 11c and 11d. A hole 17 for inserting a screw 73 is formed in each of four corners of the side walls 11a, 11b, 11c and 11d of the housing 1, and a metal sleeve 18 is inserted to the hole 17.

On inner sides of the left and right side walls 11c and 11d are formed a first step portion 11f which is lower than an upper surface of the side wall, and on the further inner side is formed a second stage portion 11g which is further lower. The second stage portion 11g is provided for mounting the control circuit board 5 thereon, and a hole 19 to which a screw 72 for attaching the control circuit board 5 is inserted is formed in each of four corners of the second stage portion 11g.

Further, a narrow protruding portion 12 is formed in a portion close to a front cover in the wall 11d on the right side, and a connector portion 13 is integrally formed with the housing in the side wall 11c on the left side.

A relay terminal 14 is provided in the side wall 11d on the right side of the housing 1 in accordance with insert mold forming, an intermediate portion 14a of the relay terminal 14 is inserted into the housing 1, one end portion 14b is arranged in the first stage portion 11f so as to form a connection portion to the control circuit board 5, and the other end portion 14c is arranged in the protruding portion 12 so as to form a connection portion to the antenna module 4.

A connector terminal 15 is provided in the side wall 11c on the left side of the housing 1 in accordance with the insert mold forming, an intermediate portion 15a of the connector terminal 15 is inserted into the housing 1, one end portion 15b is protruded into the connector portion 13, and the other end portion 15c is arranged in the first stage portion 11f so as to form a connection portion to the control circuit board 5. On upper surfaces of the side walls 11a, 11b, 11c and 11d, a narrow groove 16a is formed in a full circle, and holes (not shown) to which a first column body 22 and a second column body 23 of the front cover 2 are inserted are formed, and a narrow groove 16b is formed in a full circle on lower surfaces thereof.

The housing is formed by resin, the connector portion 13 can be provided simply by being integrally formed with the housing 1, and the relay terminal 14 and the connector terminal 15 can be provided in an insulated state in the housing 1 without any trouble in accordance with an insert mold forming. Further, since the connector portion 13, the relay terminal 14 and the connector terminal 15 are integrally formed with the housing 1, the number of the parts assembling the radar device is reduced.

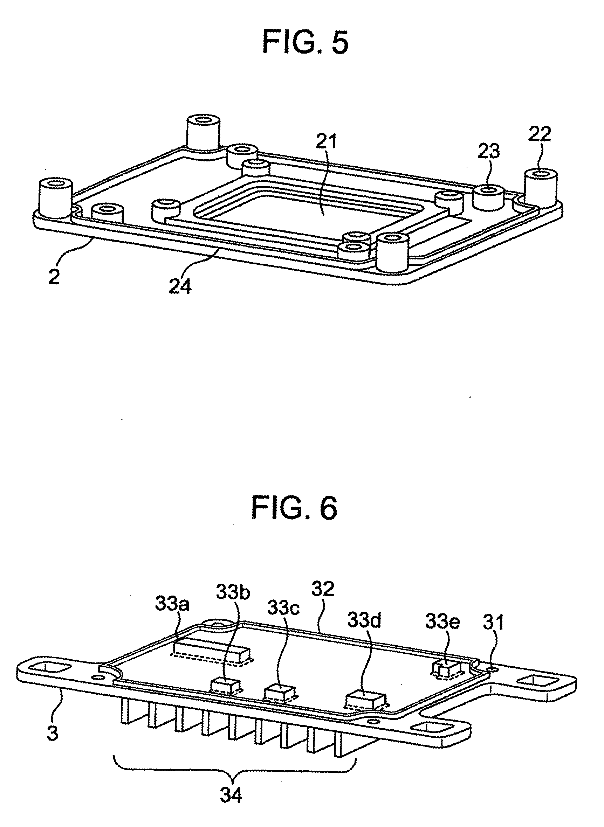

Fig. 5 is a perspective view showing details of the front cover 2. The front cover 2 is attached so as to close the opening portion in the upper side of the housing 1, and is structured in a rectangular shape by metal such as aluminum or the like, and an opening portion 21 is formed in a center thereof. The first column body 22 having a female thread formed thereon is formed at each of four corners of the front cover 2, and the second column body 23 having a female thread formed thereon is formed at each of the four corners on an inner side thereof. A narrow convex groove 24 is formed around the front cover 2, is fitted into the groove 16a of the housing 1, and seals so as to prevent rain water or the like from making an intrusion into the housing 1. A narrow groove 25 (Fig. 3) is formed around the opening portion 21 in an outer surface of the front cover 2.

Fig. 6 is a perspective view showing details of the rear cover 3. The rear cover 3 is attached so as to close the opening portion in the lower portion of the housing 1, and is formed in a rectangular shape by metal such as aluminum or the like, and a hole 31 is formed at each of four corners thereof. Further, a convex ridge 32 is formed around the inner surface of the rear cover 3, is fitted into a groove 16b formed in the housing 1, and seals so as to prevent rain water or the like from making an intrusion into the housing 1. Further, thermally conductive blocks 33a, 33b, ... 33e, ... are formed on an inner surface of the rear cover 3, convex blocks such as a heat radiation fin 34 or the like are formed on an outer surface, and heat generated by the control circuit board 5 is absorbed by the thermally conductive blocks 33 (convex blocks on the inner surface) and is discharged to the outside by the heat radiation fins 34 (the convex blocks on the outer surface).

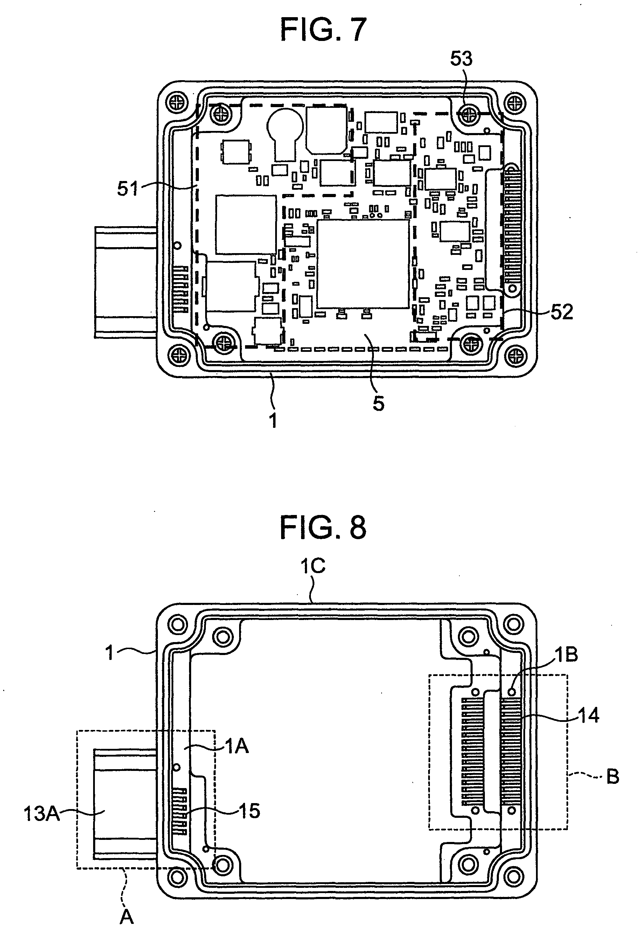

Fig. 7 shows details of the control circuit board 5, and is a plan view showing a state in which the control circuit board 5 is attached to the housing 1. The control circuit board 5 is provided with a power supply circuit portion 51 and a high-frequency circuit portion 52, the power supply circuit portion 51 is arranged so as to be collected close to the connector portion 13 of the housing 1, and the high-frequency circuit portion 52 is arranged at a position which is away from the power supply circuit portion 51. This is for preventing the matter that a sensitivity of detection is deteriorated by a superimposition of noise generated from the power supply circuit portion 51 on the high-frequency circuit portion 52, and thereby, the erroneous detection is caused. Further, a mounting hole 53 for attaching the control circuit board 5 is formed at each of four corners of the control circuit board 5.

Next, a description will be given of an assembling procedure of the radar device in accordance with the present invention on the basis of the accompanying drawings.

In order to improve an assembling efficiency, it is preferable to employ a structure in which all of the constituting members can be assembled from one side. The radar device in accordance with the present invention is structured such that the antenna module 4 and the radome 6 are first installed in the metal front cover 2, and the other members can be assembled in order from one side.

In other words, the radar device is assembled by arranging the antenna module 4 in the opening portion 21 of the metal front cover 2 from the outside, firmly attaching the peripheral edge of the antenna module 4 to the peripheral edge of the opening portion 21 by brazing material such as solder or the like or adhesive agent, further fitting a convex ridge 61 of the radome 6 for protecting the antenna in a groove 25 formed around the opening portion 21 so as to be firmly attached by adhesive agent, so as to cover the opening portion 21. In the case that the attachment of the radome 6 is reinforced by a screw 71, the screw 71 is formed by synthetic resin so as to be prevented from forming an obstacle to the transmission and receiving of the electric wave.

Next, adhesive agent is applied to the groove 16a or the like on the upper side of the resin housing 1, the housing 1 is arranged on the front cover 2 to which the antenna module 4 and the radome 6 are attached, and the housing 1 and the antenna module 4 are adhered by the adhesive agent so as to be fixed. At this time, since the connection portion of the antenna module 4 is arranged close to the connection portion (the other end portion 14c) of the relay terminal 14 provided in the housing 1, the connection portion of the antenna module 4 is connected to the connection portion of the relay terminal 14 by a wire lead 81 in accordance with a wire bonding connection. It is not necessary to use a harness or the like for connecting the connection portion of the antenna module 4 and the connection portion of the relay terminal 14, it is possible to automatically connect the relay terminal 14 and the antenna module 4, and it is possible to achieve cost reduction.

Further, the control circuit board 5 is mounted to the second stage portion 11g of the housing 1, the screws 72 are inserted to the holes 53 formed at four corners of the control circuit board 5 and the holes 19 of the housing 1, and the screws 72 are engaged with the female threads of the second column bodies 23 of the front cover 2 so as to fix the control circuit board 5. At this time, since the connection portion of the control circuit board 5 and the connection portion (one end portion 14b) of the relay terminal 14 are arranged close to each other, and the connection portion of the control circuit board 5 and the connection portion (the other end portion 15c) of the connector terminal 15 are arranged close to each other, these portions are connected by the wire leads 82 and 83 in accordance with wire bonding connection. Since it is possible to connect without using any wire harness, and it is possible to automatically connect them, it is possible to reduce cost.

The radar device is assembled finally by applying the adhesive agent to the groove 16b or the like of the housing 1, fitting the convex ridge 32 of the rear cover 3 to the groove 16b, inserting the screws 73 to the holes 31 of the rear cover 3 and the sleeves 18 of the housing 1, engaging with the female thread of the first column body 22 of the front cover 2 so as to couple the front cover 1 and the rear cover 3 by the screws 73, and fastening the front cover 1 and the rear cover 3 to the housing 1.

In the present embodiment, since after constructing by assembling the housing 1, the control circuit board 5 and the rear cover 3 to the front cover 2 in order from one side, the screws 73 from the rear cover 3 are engaged with the metal front cover 2, it is possible to firmly attach the front cover 2 and the rear cover 3 to the housing 1, it is possible to assemble the radar device in order from one side, and it is possible to automatically construct it. Further, since a screw head is not arranged in the front cover 2 at which the antenna module 4 is positioned, the transmission and receiving of the electric wave is not obstructed in the antenna module 4.

Since the constructed radar device is structured such that the thermally conductive blocks 33 (the convex blocks on the inner surface) of the rear cover 3 are arranged close to the heat generating portion of the control circuit board 5, the heat generated in the circuit board 5 is absorbed by the thermally conductive blocks 33 and is radiated to the outside from the heat radiating fins 34 (the convex blocks on the outer surface). Further, if the structure is made such that the thermally conductive block 33 comes into contact with the control circuit board 5 at a time of attaching the rear cover 3 to the housing 1, or the structure is made such that the thermally conductive block 33 and the control circuit board 5 are adhered by thermal conductive adhesive agent applied to the thermally conductive block 33 or a thermal conductive sheet adhered to the thermally conductive block 33 or the like, the heat of the control circuit board 5 is conducted to the thermally conductive block 33 via the adhesive agent or the sheet or the like, and it is possible to more effectively absorb the heat generated in the control circuit board 5 by the rear cover 3. Since the sleeve 18 inserted to the hole 17 of the housing 1 is made of metal, a slack is not generated in the screw 73 even if the resin constituting the housing is contracted, and the potential of the antenna module 4 flows to the rear cover by the metal sleeve 18 so as to be kept at a ground level.

As mentioned above, since the radar device in accordance with the present embodiment can be constructed from one side in all the works including the attaching work between the front cover 2 and the housing 1, the wire bonding connecting work between the antenna module and the relay terminal, the attaching work of the control circuit board to the housing 1, the wire bonding connecting work among the control circuit board, the relay terminal and the connector terminal, the attaching work of the rear cover 3 to the housing 1, and the coupling work of the rear cover 3 to the housing 1 in accordance with the insertion of the screw 73, it is possible to efficiently execute the constructing work, it is possible to automatically construct and it is possible to achieve cost reduction.

Fig. 8 is a plan view showing the other embodiment of the housing 1, and an explanatory view in the case that the housing 1 is structured by resin and metal. The housing is structured by synthetic resin in a portion A and a portion B in Fig. 8, a housing 1C formed by metal is formed narrow in the portion A and the portion B, and synthetic resin housings 1A and 1B are formed so as to wrap the metal housing 1C formed narrow. A connector portion 13A is integrally formed with the housing 1A formed by synthetic resin, and a connector terminal 15 is provided in accordance with the insert mold forming. The housing 1B formed by synthetic resin is provided with a relay terminal 14 relaying the antenna module 4 and the control circuit board 5 in accordance with the insert mold forming. The housing 1 in accordance with the embodiment can radiate the heat generated in the control circuit board 5 and the antenna module 4 by the metal portion, and the relay terminal 14 and the connector terminal 15 can be simply provided in the housing without applying any insulating treatment, by insert molding the relay terminal 14 and the connector terminal 15 in the housings 1B and 1C formed by synthetic resin.

The description is given in detail above of the embodiments in accordance with the present invention, however, the present invention is not limited to the embodiments mentioned above, but can be variously modified within the scope of the invention described in claims. For example, in the embodiments, the antenna module 4 is arranged in the opening portion 21 of the front cover 2 from the outside, however, the antenna module 4 may be arranged in the opening portion 21 from the inside so as to fix the peripheral edge of the antenna module 4 to the peripheral edge of the opening portion 21, or the antenna module 4 and the radome 6 may be simultaneously fixed to the front cover 2 by the adhesive agent or the like in a state in which the antenna module 4 is previously fixed to the radome 6 by the adhesive agent or the like.

The above features and embodiments can be combined partly or as a whole.

## Claims

1. A radar device having an antenna module and a control circuit thereof, said radar device comprising:
a resin housing (1) having opening portions on upper and lower sides;
a control circuit board (5) provided with said control circuit and mounted within said housing (1) ;
a metal front cover (2) attached to said housing (1) so as to close said upper opening portion of said housing (1); and
a metal rear cover (3) attached to said housing (1) so as to close said lower opening portion of said housing (1),
wherein an opening portion (21) is provided in said front cover (2), a peripheral edge of said antenna module (4) is firmly attached to an opening edge of said opening portion (21), and said opening portion (21) is coated by a radome (6) having good electric wave permeability.

2. The radar device as claimed in claim 1, wherein a connector portion (13) is integrally formed with said resin housing (1), and a relay terminal (14) relaying said antenna module (4) and said control circuit board (5), and a connector terminal (15) are provided in accordance with insert mold forming.

3. A radar device having an antenna module and a control circuit thereof, said radar device comprising:
a housing (1) having opening portions on upper and lower sides and made of resin and metal;
a circuit control board (5) provided with said control circuit and mounted within said housing (1);
a metal front cover (2) attached to said housing (1) so as to close said upper opening portion of said housing (1); and
a metal rear cover (3) attached to said housing (1) so as to close said lower opening portion of said housing (1),
wherein said housing (1) is structured by resin in a portion in which a relay terminal (14) relaying said antenna module (4) and said control circuit board (5) is arranged, and in a portion in which a connector portion (13) is provided, said connector portion (13) is integrally formed with said housing (1), and said relay terminal (14) and a connector terminal (15) are provided in said housing (1) in accordance with insert mold forming, and
wherein an opening portion (21) is provided in said front cover (2), a peripheral edge of said antenna module (4) is firmly attached to an opening edge of said opening portion (21), and said opening portion (21) is coated by a radome (6) having good electric wave permeability.

4. The radar device as claimed in any one of claims 1 to 3, wherein said front cover (2) and said rear cover (3) are attached to said housing (1) by threadedly engaging screws from said rear cover (3) with said front cover (2).

5. The radar device as claimed in any one of claims 1 to 4, wherein a connection portion of said antenna module (4) and a connection portion of said relay terminal (14) are arranged close to each other, and are connected in accordance with wire bonding, soldering of a lead wire or the like.

6. The radar device as claimed in any one of claims 1 to 5, wherein a connection portion of said control circuit board (5) and a connection portion of said connector terminal (15) are arranged close to each other, said connection portion of said control circuit board (5) and said connection portion of the relay terminal (14) are arranged close to each other, and they are respectively connected in accordance with wire bonding, soldering of a lead wire or the like.

7. The radar device as claimed in any one of claims 1 to 6, wherein said metal rear cover (3) is provided with a convex block at least on an inner surface.
